## Europäisches Patentamt
## European Patent Office
## Office européen des brevets

(11) Publication number: **0 121 268**
**B1**

(12) **EUROPEAN PATENT SPECIFICATION**

(45) Date of publication of patent specification: **06.04.88**

(51) Int. Cl.⁴: **H 01 L 23/50, H 01 L 21/60**

(21) Application number: **84200052.3**

(22) Date of filing: **16.01.84**

(54) Flat-card-shaped semiconductor device with electric contacts on both faces and process for its manufacture.

(30) Priority: **09.03.83 IT 1996383**

(43) Date of publication of application:
**10.10.84 Bulletin 84/41**

(45) Publication of the grant of the patent:
**06.04.88 Bulletin 88/14**

(84) Designated Contracting States:
**BE CH DE FR GB LI NL SE**

(56) References cited:
**DE-A-2 939 502**
**GB-A-1 225 668**
**US-A-3 702 464**
**US-A-4 018 491**

(73) Proprietor: **SGS MICROELETTRONICA S.p.A.**
**Stradale Primosole 50**
**I-95121 Catania (IT)**

(72) Inventor: **Marchisi, Giuseppe**
**Via Pecorini, 8**
**I-20138 Milano (IT)**

(74) Representative: **Mittler, Enrico**
**c/o Marchi & Mittler s.r.l. Viale Lombardia, 20**
**I-20131 Milano (IT)**

Courier Press, Leamington Spa, England.

## Description

The present invention relates to a flat-card-shaped semiconductor device with electric contacts on both faces, as well as a process for its manufacture.

There are known and used, above all in the field of televison electronic games, card-shaped semiconductor devices, where on both faces of an insulating support in glass fiber and epoxide resin there are formed by superficial metallization respective series of electric contacts connected to a semiconductor chip deposited and duly encapsulated on a face of the same insulating support.

Particularly, US—A—3702464 describes a semiconductor device in the form of a card, comprising an insulating support plate provided with a series of conductors, a semiconductor chip mounted on the support plate and electrically connected to the conductors, and a covering for the chip, the contact portions of the conductors being exposed for electrical connections.

Such known devices present the disadvantages of being too expensive, above all as a consequence of the high cost of the insulating support and of the laboriousness of the formation process of the electric contacts.

The object of the present invention is to realize a semiconductor device of flat-card kind with electric contacts on the two opposite faces, which results less expensive than those presently known which have been previously mentioned.

According to the invention such an object has been reached by means of a semiconductor device, comprising a flat insulating support member, a semiconductor chip and two series of electrical contacts, characterized in that said electrical contacts are constituted by sheet metal strips electrically connected to a semiconductor chip carried by a metallic support pad said flat support comprises a highly insulating layer of adhesive material interposed between the two series of electrical contacts, and a covering or package of insulating material is provided through which only contact portions of the two series of electrical contacts emerge at the opposite faces of the covering.

Always according to the invention it is provided that the above mentioned device is manufactured by a process comprising the steps of providing, as a starting element, a flat metallic frame including a support pad for the semiconductor chip, the metallic frame comprising a first series of electrical contacts in the shape of sheet metal strips, mounting the semiconductor chip on the support pad, superimposing a second series of electrical contacts in the shape of sheet metal strips on said first series with interposition of a highly insulating layer of adhesive material, and finally providing a covering of insulating material to form a flat package through which only contact portions of said electrical contacts emerge at the opposite faces of the covering.

It is also provided that, in practical realization of the above mentioned process, the second series of contacts is either contained in the same starting metallic frame, on the opposite part with respect to the first series, and then refolded on the first one, or separately prepared and then applied on the first one. It is clear that they are two completely equivalent solutions.

From comparative tests effected, it has appeared that the device according to the invention, for its shape and for its manufacture way, is less expensive than the card-shaped ones of known kind. This is above all due to the fact that we do not resort, as in the prior art, to an expensive preformed card, but to more simple constructive elements, such as metallic frames which can be obtained by shearing, the cost of which is certainly reduced. Besides, it is avoided the difficult process of deposition of the electric contacts on the above mentioned card.

Besides it has been noted that the device according to the invention offers greater guarantees of reliability. This is in fact the result of the fact that the whole system of contacts is included in the insulating covering, except for the only contact portions.

Finally it has been found that the device according to the invention offers the same cost and reliability advantages of the normal integrated circuits of the so called "dual-in-line" kind, having with respect to them the quality of the flat card conformation, in many cases useful for its reduced bulk and the ready substitution in case of necessity.

The characteristics and the advantages of the present invention will be made more evident by the following detailed description of an embodiment illustrated by way of non-limitative example in the enclosed drawings, in which:

Fig. 1 shows in top plan view a metallic frame with two contact series, which constitutes the starting element for obtaining a semiconductor device according to the invention;

Fig. 2 shows said frame in section after it has received the semiconductor chip and a series of contacts has been folded under the other one with interposition of a layer of adhesive material at high insulation;

Fig. 3 shows in top plan the semiconductor device at the end of the process;

Fig. 4 shows said device in section along line IV—IV of Fig. 3.

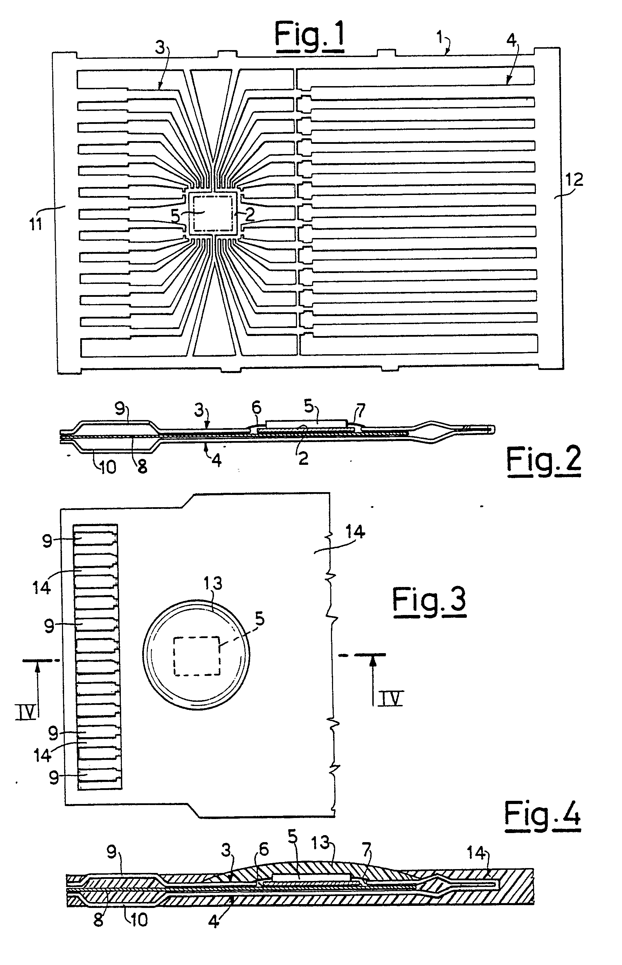

With reference to Fig. 1, there is illustrated a flat metallic frame 1, wherein there are individuated by shearing a pad 2 destined for receiving a semiconductor chip and two opposite series of electrical contacts 3 and 4 realized in the shape of thin metal-sheet strips converging towards the pad 2.

Once a semiconductor chip 5 has been deposited and fixed on the pad 2 and then electrically connected to the electrical contacts 3 and 4 by means of thin conducting filaments 6 and 7 (Figs. 1 and 2), the part of the frame 1 which comprises the contacts 4 is refolded under the pad 2 and the contacts 3 with interposition of a thin layer of high-insulating adhesive material 8, for example formed by an epoxide glue. It is also executed a preliminary drawing of the terminal portions 9 and 10 (destined for the real contact) of the contacts 3 and 4 and the end sides 11 and 12 of the frame 1 are removed, in order to electrically and mechanically separate the contacts of every series 3 and 4, on the other hand kept in position by the adhesive.

Having been executed also (before or after the contacts refolding) the encapsulation of the chip 5 in a suitable resin 13 (Figs. 3 and 4), the covering of the whole by epoxide resin 14 is finally executed, taking care of leaving emerging from the so obtained container or "package" (in addition to the encapsulated chip) only the contact portions 9 and 10 of the electrical contacts 3 and 4, distributed in two series on the opposite faces of the card (Figs. 3 and 4).

It is thus obtained a semiconductor device in the shape of a flat card, which, as illustrated in Figs. 3 and 4, contains a duly encapsulated semiconductor chip and leaves emerging from the two opposite faces of the container or "package" 14 two respective series of terminal portions 9 and 10 of electrical contacts, otherwise completely inserted in the resin.

Alternatively to the described process, as already said previously, it can be provided the use of a metallic frame with a single series of contacts and the preparation of a second series to be applied later under the first one, however finally obtaining the configuration illustrated in Fig. 2.

## Claims

1. Semiconductor device in the shape of a flat card, comprising a flat insulating support member (8), a semiconductor chip (5) and two series (3, 4) of electrical contacts, characterized in that said electrical contacts (3, 4) are constituted by sheet metal strips electrically connected to a semiconductor chip carried by a metallic support pad (2), said flat support member (8) comprises a highly insulating layer of adhesive material interposed between the two series of electrical contacts (3, 4), and a covering or package of insulating material (14) is provided through which only contact portions (9, 10) of the two series of electrical contacts (3, 4) emerge at the opposite faces of the covering (14).

2. Device according to claim 1, characterized in that said semiconductor chip (5) is provided with an encapsulant of a resin.

3. Device according to claim 1, characterized in that said layer of adhesive material (8) is formed by an epoxy glue.

4. Device according to claim 1, characterized in that said covering (14) of insulating material is formed by an epoxy resin.

5. Process for the manufacture of a semiconductor device according to claim 1, comprising the steps of providing as a starting element a flat metallic frame (1) including a support pad (2) for the semiconductor chip (5), the metallic frame (1) comprising a first series (3) of electrical contacts in the shape of sheet metal strips, mounting the semiconductor chip (5) on the support pad (2), superimposing a second series (4) of electrical contacts in the shape of sheet metal strips on said first series (3) with interposition of a highly insulating layer (8) of adhesive material between the first and second series of contacts (3, 4), and finally providing a covering (14) of insulating material to form a flat package through which only contact portions (9, 10) of the two series of contacts (3, 4) emerge at the opposite faces of the covering (14).

6. Process according to claim 5, characterized in that the second series of electric contacts (4) is also contained in said flat metallic frame (1), at the opposite part with respect to the first series (3), and then superimposed to the first one by folding.

7. Process according to claim 5, characterized in that said second series (4) of electric contacts is prepared separately and then applied on the first one (3).

8. Process according to claim 5, characterized in that, before providing said covering (14) of insulating material, encapsulation of the semiconductor chip (5) in a resin (13) is carried out.

## Patentansprüche

1. Halbleiterbauelement in Form einer flachen Karte, umfassend ein flaches isolierendes Aufnahmeteil (8), ein Halbleiterchip (5) und zwei Reihen (3, 4) elektrischer Kontakte, dadurch gekennzeichnet, daß die elektrischen Kontakte (3, 4) gebildet werden durch Metallblechstreifen, die elektrisch mit einem Halbleiterchip verbunden sind, welches mit einem metallischen Aufnahmeflachstück (2) verbunden ist, das flache Aufnahmeteil (8) eine gut isolierende Schicht aus Klebstoff aufweist, die sich zwischen den beiden Reihen von elektrischen Kontakten (3, 4) befindet, und eine Abdeckung oder Einkapselung aus Isolierstoff (14) vorgesehen ist, durch die hindurch nur Kontaktabschnitte (9, 10) der beiden Reihen elektrischer Kontakte (3, 4) an entgegengesetzten Seiten der Abdeckung (14) in Erscheinung treten.

2. Bauelement nach Anspruch 1, dadurch gekennzeichnet, daß das Halbleiterchip (5) mit einer Einkapselung aus einem Harz versehen ist.

3. Bauelement nach Anspruch 1, dadurch gekennzeichnet, daß die Schicht aus Klebstoff (8) durch einen Epoxykleber gebildet ist.

4. Bauelement nach Anspruch 1, dadurch gekennzeichnet, daß die Abdeckung (14) aus Isolierstoff durch ein Epoxyharz gebildet ist.

5. Verfahren zum Herstellen eines Halbleiterbauelements nach Anspruch 1, umfassend die Schritte: Bereitstellen eines flachen Metallrahmens (1) mit einem Aufnahmeflachstück (2) für das Halbleiterchip (5) als Ausgangselement, wobei der Metallrahmen (1) eine erste Reihe (3) elektrischer Kontakte in Form von Metallblechstreifen aufweist, Montieren des Halbleiterchips (5) auf dem Aufnahmeflachstück (2), Auflegen einer zweiten Reihe (4) elektrischer Kontakte in Form von Metallblechstreifen auf die erste Reihe (3) unter Zwischeneinfügung einer gut isolierenden Schicht (8) aus Klebstoff zwischen die erste und die zweite Reihe von Kontakten (3, 4), und — schließlich — Vorsehen einer Abdeckung (14) aus Isolierstoff, um eine flache Packung zu bilden, durch die nur Kontaktabschnitte (9, 10) der beiden Reihen von Kontakten (3, 4) an entgegengesetzten Seiten der Abdeckung (14) in Erscheinung treten.

6. Verfahren nach Anspruch 5, dadurch gekennzeichnet, daß die zweite Reihe von elektrischen Kontakten (4) ebenfalls in dem flachen Metallrahmen (1), an dem der ersten Reihe (2) entgegengesetzten Teil, enthalten ist, und die dann durch Umfalten der ersten Reihe überlagert wird.

7. Verfahren nach Anspruch 5, dadurch gekennzeichnet, daß die zweite Reihe (4) von elektrischen Kontakten getrennt vorbereitet und dann an der ersten Reihe (3) angebracht wird.

8. Verfahren nach Anspruch 5, dadurch gekennzeichnet, daß, bevor die Abdeckung (14) aus Isolierstoff vorgesehen wird, das Halbleiterchip (5) in einem Harz (13) eingekapselt wird.

**Revendications**

1. Dispositif semiconducteur sous la forme d'une plaquette comprenant un organe-support plat isolant (8), une plaquette de semiconducteur (5) et deux séries (3, 4) de contacts électriques, caractérisé en ce que lesdits contacts électriques (3, 4) sont constitués par des bandes de métal en feuille électriquement reliées à une plaquette de semiconducteur portée par un petit plateau métallique (2), ledit organe-support (8) comprend une couche très isolante de matière adhésive interposée entre les deux séries de contacts électriques (3, 4), et il est prévu un recouvrement ou emballage de matière isolante (14) d'où n'émergent, sur les faces opposées du recouvrement (14), que des parties contact (9, 10) des deux séries de contacts électriques (3, 4).

2. Dispositif selon revendication 1, caractérisé en ce que ladite plaquette de semiconducteur (5) est pourvue d'un encapsulant fait d'une résine.

3. Dispositif selon revendication 1, caractérisé en ce que ladite couche de matière adhésive (8) est formée par de la colle époxy.

4. Dispositif selon revendication 1, caractérisé en ce que ledit recouvrement en matière isolante est formé par une résine époxy.

5. Procédé de fabrication d'un dispositif semiconducteur selon la revendication 1, comprenant les étapes suivantes: on fournit, comme élément de départ, un châssis métallique plat (1) incluant un petit plateau (2) pour la plaquette de semiconducteur (5), le châssis métallique (1) comprenant une première série (3) de contacts électriques sous forme de bandes de métal en feuille, on monte la plaquette de semiconducteur (5) sur le petit plateau (2), on superpose à la première série (3) une deuxième série (4) de contacts électriques sous forme de bandes de métal en feuille, cela avec interposition d'une couche très isolante (8) de matière adhésive entre la première et la deuxième série de contacts (3, 4), et on applique finalement un recouvrement (14) de matière isolante, pour former un emballage plat d'ou n'émergent, sur des faces opposées du recouvrement (14), que des parties contact (9, 10) des deux séries de contacts (3, 4).

6. Procédé selon revendication 5, caractérisé en ce que la deuxième série de contacts électriques (4) est aussi contenue dans ledit châssis métallique plat (1), à la partie opposée par rapport à la première série (3), puis superposée à la première par pliage.

7. Procédé selon revendication 5, caractérisé en ce que ladite deuxième série (4) de contacts électriques est préparée séparément puis appliquée sur la première (3).

8. Procédé selon revendication 5, caractérisé en ce qu'avant d'appliquer ledit recouvrement (14) de matière isolante, on encapsule la plaquette de semiconducteur (5) dans une résine (13).

Fig.1

Fig.2

Fig.3

Fig.4